(19) **Europäisches Patentamt**
**European Patent Office**
**Office européen des brevets**

(11) **EP 2 008 294 B1**

(12) **EUROPÄISCHE PATENTSCHRIFT**

(45) Veröffentlichungstag und Bekanntmachung des Hinweises auf die Patenterteilung:
**24.09.2014 Patentblatt 2014/39**

(21) Anmeldenummer: **07722144.8**

(22) Anmeldetag: **31.03.2007**

(51) Int Cl.:
***H01J 37/153*** (2006.01)

(86) Internationale Anmeldenummer:
**PCT/DE2007/000586**

(87) Internationale Veröffentlichungsnummer:
**WO 2007/118450 (25.10.2007 Gazette 2007/43)**

(54) **ELEKTRONENOPTISCHER KORREKTOR FÜR APLANATISCHE ABBILDUNGSSYSTEME**

ELECTRON-OPTICAL CORRECTOR FOR APLANATIC IMAGING SYSTEMS

CORRECTEUR OPTOÉLECTRONIQUE POUR SYSTÈMES DE REPRÉSENTATION APLANÉTIQUES

(84) Benannte Vertragsstaaten:
**CZ DE GB NL**

(30) Priorität: **15.04.2006 DE 102006017686**

(43) Veröffentlichungstag der Anmeldung:
**31.12.2008 Patentblatt 2009/01**

(73) Patentinhaber: **Ceos Corrected Electron Optical Systems GmbH**
**69126 Heidelberg (DE)**

(72) Erfinder:
• **UHLEMANN, Stephan**
**69115 Heidelberg (DE)**
• **ROSE, Harald**
**64287 Darmstadt (DE)**

• **MÜLLER, Heiko**
**69115 Heidelberg (DE)**

(74) Vertreter: **Pöhner, Wilfried Anton**
**Patentanwalt Dr. W. Pöhner**
**Kaiserstrasse 33**
**Postfach 6323**
**97013 Würzburg (DE)**

(56) Entgegenhaltungen:
**DE-A1- 19 802 409      GB-A- 1 365 382**

• **ROSE H ET AL: "Optimization of imaging magnetic energy filters free of second-order aberrations" OPTIK, WISSENSCHAFTLICHE VERLAG GMBH.STUTTGART, DE, Bd. 54, Nr. 3, 1979, Seiten 235-250, XP009087385 ISSN: 0030-4026**

**Beschreibung**

Die Erfindung bezieht sich auf einen teilchenoptischen Korrektor zur Beseitigung sowohl des Öffnungsfehlers dritter Ordnung als auch der außeraxialen Koma dritter Ordnung unter Verwendung von Rundlinsen und Hexapolfeldern.

Die Leistungsfähigkeit hochauflösend abbildender elektronenoptischer Systeme, wie z. B. in der hochauflösenden Elektronenmikroskopie, wird durch den Öffnungsfehler dritter Ordnung begrenzt. Ein wesentliches Anliegen der Weiterentwicklung derartiger Systeme ist deshalb die Beseitigung des Öffnungsfehlers dritter Ordnung. Ein neben der Hochauflösung weiterhin wichtiges Kriterium der Leistungsfähigkeit ist, einen Bildbereich hinreichender Größe abbilden zu können. Dessen Grenze wird in hochauflösenden elektronenoptischen Systemen durch den Bildfehler der außeraxialen Koma bestimmt, der sich zusammensetzt aus den Anteilen der radialen Koma, häufig auch als isotrope Koma bezeichnet und der azimutalen Koma, die auch als anisotrope Koma benannt wird. Demnach stehen im einen Begriff-system radial und azimutal, im anderen Begriffsystem die Bezeichnungen isotrop und anisotrop gegenüber. Gemäß üblicher Terminologie werden elektronenoptische Abbildungssysteme, welche sowohl keinen Öffnungsfehler dritter Ordnung als auch keine außeraxiale Koma aufweisen, als Aplanate bezeichnet. Hiervon abgeleitet werden Systeme als Semi-Aplanate bezeichnet, wenn sie neben der Öffnungsfehlerfreiheit dritter Ordnung lediglich frei von radialer (isotroper) Koma sind. Bei elektronenoptischen Systemen mit gerader Achse und rundem Gauß'schen Strahlengang, die im Folgenden stets vorausgesetzt werden, besteht der Öffnungsfehler dritter Ordnung aus der sphärischen Aberration dritter Ordnung. Dabei werden unter Öffnungsfehler all jene Bildfehler zusammengefasst, in deren Fehlerintegralen nur jene Gauß'schen Elementarbahnen eingehen, die von der optischen Achse in der abzubildenden Gegenstandsebene ausgehen. Die Größe des abzubildenden Gegenstands-/Bildfeldes wird hingegen durch die außeraxialen Fehler bestimmt, also jene Fehler, in deren Fehlerintegrale auch Elementarbahnen nach der Gauß'schen Dioptrik enthalten sind, die in der Gegenstandsebene außerhalb der optischen Achse ausgehen. In der hochauflösenden Elektronenoptik steht der Bildfehler der außeraxialen Koma bei der Begrenzung des Bildfeldes im Vordergrund.

In der auf die Anmelderin zurückgehenden Patentanmeldung DE 198 02 409 wird bereits ein Korrektiv beschrieben, bei dem zwei Hexapole Verwendung finden, zwischen denen ein Rundlinsenduplett eingebracht ist. Zwischen dem aus diesen Linsen bestehenden Korrektiv und der Objektivlinse wird eine weitere Rundlinse eingebracht in der Weise, dass die komafreie Ebene der Objektivlinse in die komafreie Ebene des Korrektivs abgebildet wird. Der Begriff "komafreie Ebene", oder genauer "komafreie Blendenebene", bezeichnet aber genau genommen die Eigenschaft "frei von isotroper (radialer) Koma". Ein Korrektiv dieses Aufbaues gestattet also die Beseitigung des Öffnungsfehlers dritter Ordnung (Sphärische Aberration 3. Ordnung) der Objektivlinse unter Vermeidung des radialen (isotropen) Anteiles der außeraxialen Koma. Nach der üblichen und oben näher erläuterten Terminologie stellt das System, bestehend aus Objektivlinse, Transfersystem und Korrektiv, im Ergebnis einen Semi-Aplanaten dar.

Bei der beschriebenen Anordnung ist von Nachteil, dass durch die unvermeidliche anisotrope außeraxiale Koma der magnetischen Objektivlinse, die von dem Korrektiv unbeeinflusst gelassen wird, eine Einschränkung des scharf abgebildeten Bildbereiches stattfindet, der durch eine vollständige Beseitigung dieses Bildfehlers eine wesentliche Vergrößerung erfahren könnte.

In der auf die Anmelderin zurückgehenden Patentanmeldung 10 2005 05 0810.3 wird weiterhin ein Korrektiv beschrieben, bei dem drei oder mehr Hexapolfelder Verwendung finden, zwischen denen Rundlinsen eingebracht sind. Diese Systeme erlauben die gleichzeitige Korrektur des Öffnungsfehler 3. Ordnung und der außeraxialer Koma 3. Ordnung, wobei alle Hexapolfelder von vergleichbarer Stärke und teilweise gegeneinander verdreht angeordnet sind. In dieser Anmeldung sind Systeme mit drei, fünf bzw. sechs starken Hexapolfeldern beschrieben, wobei jeweils die Schwerpunkte der Hexapolfelder von den dazwischen angeordneten Rundlinsen aufeinander abgebildet werden. Die Systeme mit fünf und mehr starken Hexapolfeldern sind auf Grund ihrer Länge und Komplexität als nachteilig erkannt worden. Das System mit nur drei starken Hexapolen bietet nicht die Freiheit die Korrekturkraft durch Wahl der Zwischenvergrößerung zwischen Objektivlinse und Korrektiv elektrisch anzupassen, ohne dass sich die optische Qualität der Abbildung verschlechtert. Diese Einschränkung beschränkt die Anwendbarkeit dieser Korrektive auf spezielle Anwendungen, bei denen auf eine Anpassung der Korrekturkraft an den Betriebszustand des abbildenden Systems verzichtet werden kann.

Davon ausgehend hat sich die Erfindung die Schaffung eines elektronenoptischen Korrektivs zur Aufgabe gemacht, welches neben der Beseitigung des Öffnungsfehlers dritter Ordnung auch eine Beseitigung der azimutalen (anisotropen) außeraxialen Koma sowie die des dreizähligen Astigmatismus 2. Ordnung gestattet.

Gelöst wird diese Aufgabe erfindungsgemäß durch die im Anspruch 1 angegebenen Merkmale.

Die Stärkenverhältnisse der Hexapolfelder sind derart gewählt, dass die Bildfehlerkoeffizienten des axialen dreizähligen Astigmatismus 2. Ordnung zu 0 wird. Der nach Festlegung der Stärkenverhältnisse übrig bleibende Stärkenparameter wird zur Einstellung der Korrektur des Öffnungsfehlers genutzt.

Zusätzlich enthält das Korrektiv zwei Paare von Hexapolfeldern zur Korrektur der außeraxiale Koma 3. Ordnung, die um die genannten Zwischenebenen herum angeordnet sind. Die Stärken der genannten Hexapolfeldpaare sind vorzugsweise um einen Faktor von mindestens 10, typischerweise jedoch 50 bis 100, niedriger als der anderen Hexapolfelder. Der Vorteil der geringen Stärken der Hexapolfeldpaare besteht vornehmlich in der Einfachheit der baulichen Realisierung.

Die Korrektur der außeraxialen Koma 3. Ordnung wird bewirkt durch die beiden Paare von Hexapolfelder. Die gemeinsame Orientierung dieser Paare relativ zur Orientierung der starken Hexapolfelder muss entsprechend der zu korrigierenden außeraxialen Koma eingestellt werden. Eine besonders bevorzugte Variante des Korrektivs dient der Korrektur des anisotropen (azimutalen) Anteils der außeraxialen Koma einer magnetischen Objektivlinse. In diesem speziellen Fall sind die schwachen Hexapolfelder gemessen im Larmorsystem um einen Winkel von 30° zu verdrehen.

Wie oben erläutert sind die Feldstärken der Hexapolfeldpaare zur Komakorrektur deutlich schwächer als die der Hexpolfelder zur Öffnungsfehlerkorrektur. Diese Eigenschaft führt zu einer weitgehenden Entkopplung dieser Korrekturfreiheitsgrade des Korrektivs, was sich in der Praxis sehr günstig auswirkt.

In der Praxis werden bevorzugt die Hexapole raumfest gehalten und die Hexapolfeldpaare relativ hiergegen elektrisch oder mechanisch soweit verdreht, bis die Elimination des Bildfehlers der außeraxialen Koma erfolgt. Die Vorgehensweise kann entweder durch experimentelles Justieren oder aber auch durch mathematisches Ermitteln des Drehwinkels und einer Einstellung demzufolge vorgenommen werden. Auf diese Weise erhält man ein Korrektiv, das neben dem Öffnungsfehler dritter Ordnung zusätzlich auch die azimutale Komponente der außeraxiale Koma dritter Ordnung zu eliminieren gestattet.

Aufgrund der vorhandenen axialen Magnetfelder erfolgt eine Drehung der Bahn der Elektronen, im Allgemeinen des elektrisch geladenen Partikelstroms. Eine Vereinfachung der Beschreibung der physikalischen Gegebenheiten lässt sich durch die Darstellung in einem Koordinatensystem erreichen, das sich entsprechend der drehenden Bewegung der Elektronen mitbewegt und das als Larmor-Bezugssystem bezeichnet wird. Die im Rahmen dieser Erfindung beschriebene Drehung der Hexapolfelder ist stets relativ zum Larmor-Bezugssystem gemessen.

Die Aufgabe eines Korrektivs besteht darin, die Bildfehler einer Objektivlinse, mit der das Korrektiv zusammenarbeitet, zu eliminieren oder doch zumindest zu verringern. Dabei steht im Rahmen der Erfindung grundsätzlich frei, ob das Korrektiv und das Transferlinsensystem der Linse vor- oder nachgeschaltet wird. Im Folgenden wird die zu korrigierende Linse, also die Objektivlinse, die in der Regel eine Magnetlinse sein wird, unerwähnt bleiben und primär der Aufbau des Korrektivs beschrieben.

Der axiale Dreilappfehler wird minimiert, wenn die Einstellung der Rundlinendupletts so erfolgt, dass die Mittelebene des mittleren Hexapolfeldes auf die diesem jeweils zugewandte Eintrittsebene des ersten bzw. letzten Hexapolfeldes abgebildet wird.

Im allgemeinsten Fall nicht erforderlich jedoch von Vorteil ist ein teleskopischer Strahlengang zwischen den Hexapolen. Durch diese Maßnahme vereinfachen sich Einstellung und Justierung des Korrektors. Aufgrund der bestehenden Symmetrien/Antisymmetrien des Strahlengangs reduzieren sich und/oder verschwinden zahlreiche residuale Bildfehler.

Eine besonders bevorzugte Ausführungsform des Korrektivs ist gegeben durch eine zur Mittelebene des Systems symmetrische Anordnung der optischen Elemente, wobei die Stärken der Rundlinsenfelder und der Hexapolfelder symmetrisch zur Mittelebene sind. Im Gegensatz dazu erfolgt die Erregung der Hexapolfeldpaare antisymmetrisch zur Mittelebene.

Der Verlauf der axialen Fundamentalbahn ist symmetrisch zur Mittelebene eingestellt, während die außeraxiale Fundamentalbahn antisymmetrisch zur Mittelebene verläuft.

Der symmetrische Aufbau des Korrektivs und der symmetrische Strahlengang bewirken vorteilhaft, dass der axiale Dreilappfehler (dreizähliger Öffnungsfehler 4. Ordnung), der durch das Korrektiv eingeführt wird, klein bleibt.

Der in diesem System immer noch vorhandene axiale Dreilappfehler ist ein Nebeneffekt der Rundlinsen des Korrektivs die einen Teilchenstrahl mit dreizähligem Querschnitt fokussieren. Eine vollständige Korrektur des axialen Dreilappfehlers wird durch eine angepasste Modifikation der Rundlinsen des Korrektivs erreicht. Die Geometrie der feldformenden Teile (magnetischer Spalt) der Rundlinsen, die dem mittleren Hexapolfeld zugewandt sind, wird so verändert, dass der Öffnungsfehler dritter Ordnung dieser Rundlinsen bei gleicher Brechkraft zunimmt. Man erreicht dies durch ein Verringerung der Länge des magnetischen Spaltes und/oder eine Verringerung des Bohrungsdurchmessers. Der Linsenstrom wird dabei vermindert um die Brechkraft der Linsen konstant zu halten. Mit dieser Maßnahme kann der residuale Dreilappfehler des Systems minimiert oder sogar vollständig kompensiert werden.

Weiterhin ergibt sich eine besonders einfache Ausführungsform des Korrektivs, wenn man die Brennweiten der beiden Transferlinsen der Rundlinsendupletts f=f' gleich wählt. In diesem speziellen Fall muss die effektive Länge des mittleren Hexapolfeldes gleich dem Doppelten der Länge der äußeren Hexapolfelder gewählt werden. Die Hexapolfeldstärken der äußeren und des mittleren Hexapolfelds sind dabei gleich. Diese Wahl der Längen- und Stärkenparameter bewirkt das geforderte gleichzeitige Verschwinden des axialen dreizähligen Astigmatismus 2. Ordnung und der dreizähligen Verzeichnung 2. Ordnung in besonders einfacher Weise. Für diesen doppelsymmetrischen Aufbau ist der Verlauf der axialen Fundamentalbahn zusätzlich antisymmetrisch zu den Zwischenebenen und der der außeraxialen Fundamentalbahn symmetrisch zu den Zwischenebenen.

Wählt man die Brennweiten der beiden Transferlinsen der Rundlinsendupletts jeweils unterschiedlich, so müssen die Länge und Stärke des mittleren Hexapolfelds so angepasst werden, dass wieder das geforderte gleichzeitige Verschwinden des axialen dreizähligen Astigmatismus 2. Ordnung und der dreizähligen Verzeichnung 2. Ordnung eintritt. Mit den zwei freien Parametern Längenverhältnis und Stärkenverhältnis können diese beiden Forderungen rechnerisch immer erfüllt werden. Die oben für den Fall gleicher Brennweiten f=f beschriebene Doppelsymmetrie geht damit verloren, was aber keine Nachteile bzgl. der optischen Eigenschaften des Korrektivs hat. Die Realisierung eines Brennweitenverhältnisses f/f'>1 ist darüber hinaus technisch vorteilhaft da dann die Länge des mittleren Hexapolfeldes im Vergleich zur Situation für f/f'=1 zunimmt, wenn die Länge der äußeren Hexapolfelder unverändert belassen wird. In diesem speziellen Fall ist es günstig das mittlere Hexapolfeld auf einem Multipolelement mit 12-zähliger Drehsymmetrie zu erregen. Auf dem gleichen Element kann dann ein zusätzliches Dodecapolfeld überlagert werden, welches der Korrektur des sechszähligen Astigmatismus 5. Ordnung dient. Im Ergebnis wird durch diese Maßnahme das optische Auflösungsvermögen des Abbildungssystems mit Korrektiv weiter verbessert.

Rechnerisch kann man Zusammenhänge zwischen den Brennweiten $f_1$ äußeren (20,21) und $f_2$ der innern (18,19) Rundlinsen und den Längen $L_1$ der äußeren Hexapolfelder (3,5) und $L_2$ des mittleren Hexapolfelds (4) sowie den normierten Stärken $H_1$ der äußeren Hexapolfelder (3,5) und $H_2$ der mittleren Hexapolfelds (5) angeben. Wir beschränken uns auf ein einfaches Modell, bei dem der Feldverlauf der Hexapolfelder in z-Richtung durch einen stückweise konstanten Verlauf (Kastenfeld) angenähert wird. Die Forderung, dass der axiale dreizählige Astigmatismus 2.Ordnung zu 0 wird resultiert dann in der Bedingung:

$$2f_1^3 \, H_1 \, L_1 = f_2^3 \, H_2 \, L_2.$$

Ebenso führt die Forderung, dass die dreizählige Verzeichnung zweiter Ordnung zu 0 wird zu der zusätzlichen Bedingung:

$$8H_1 L_1^3 / f_1 = H_2 L_2^3 / f_2.$$

Bei bekanntem Brennweitenverhältnis $f_1/f_2$ bestimmen diese Gleichungen das Feldstärkenverhältnis

$$H_1/H_2 = (f_2/f_1)^5,$$

sowie das Langenverhältnis

$$L_1/L_2 = 1/2 \, (f_1/f_2)^2.$$

Grundsätzlich muss man immer davon ausgehen, dass im realen System im Vergleich zum rechnerischen Modell leicht abweichende Feldstärkenwerte und Längen eingestellt bzw. gebaut werden müssen, was Randfeldeffekten, Materialeigenschaften und der endlichen Baugenauigkeit des Korrektivs geschuldet ist.

Die drei Hexapolfelder sind im Bezug auf die optische Achse gemessen im Larmor-Bezugssystem gegeneinander unverdreht. Sind die Brennweiten der Transferlinsen gleich und ihr Aufbau symmetrisch bzgl. der Mittelebenen und ihre Linsenströme bzgl. der Zwischenebenen gegenläufig orientiert, so erfolgt die Abbildung des Rundlinsendupletts verdrehungsfrei. Nur in diesem Fall sind die starken Hexapolelemente auch gemessen im Laborsystem relativ zueinander unverdreht. Bildet das Rundlinsenduplett nicht verdrehungsfrei ab, ist im Laborsystem eine entsprechende Verdrehung des mittleren Hexapolfeldes relativ zu den gleich orientierten starken äußeren Hexapolfeldern vorzuhalten.

Die Erzeugung des Hexapolfeldes steht im Rahmen der Erfindung grundsätzlich frei. Das Hexapolfeld entsteht nach Verwendung eines Multipolelementes mit 6-zähliger Drehsymmetrie. Auch ist es möglich ein Multipolelement mit 12-zähliger Drehsymmetrie zu verwenden und durch gleichsinnige Beaufschlagung benachbarte Polelemente ein Hexapolfeld zu erhalten. Durch nachträgliche Veränderung der Beaufschlagung der einzelnen Polelemente lässt sich unter Beibehaltung der mechanischen Positionierung einer Drehung und Einstellung des elektrischen und/oder magnetischen Hexapolfeldes erreichen.

In einer Ausführungsform schließlich wird eine Rundlinse aus zwei oder mehr magnetischen Linsenfeldern zusammengesetzt, so dass zur Einstellung und Justierung die jeweiligen Stärken als Parameter zur Verfügung stehen. Eine derartige Anordnung erzeugt ein Rundlinsenfeld, dass es bei entsprechender Wahl der jeweiligen Stärke möglich macht, unter Beibehaltung der Brechkraft der Rundlinse die Larmor-Drehung oder den Öffnungsfehler 3. Ordnung der Rundlinse in der gewünschten Weise zu beeinflussen. Dieser zusätzliche Freiheitsgrad kann vorteilhaft für die elektrische Feinjustage des Korrektivs genutzt werden.

Für das Transferlinsensystem zwischen Korrektor und Objektiv bestehen zwei Alternativen:

Das Transferlinsensystem kann aus einer einzigen Rundlinse bestehen, die im Hinblick auf ihre Stärke und Position so einzustellen ist, dass die komafreie Ebene der Objektivlinse in die komafreie Ebene des Korrektivs abgebildet wird.

Die Alternative besteht in der Verwendung eines Rundlinsendupletts als Transferlinsensystem zwischen Objektivlinse und Korrektor. Auch hier folgt die Einstellung in der Weise, dass die komafreie Ebene der Objektivlinse in die komafreie Ebene des Korrektivs abgebildet wird. Diese Maßnahmen sorgen dafür, dass zusätzlich zu den oben beschriebenen Bildfehlern die isotrope (radiale) Koma vermieden werden kann. Man erhält dann eine Anordnung, welche die Eigenschaften eines Aplanaten besitzt.

Die Anpassung der Korrekturkraft an den zu korrigierenden Öffnungsfehler der Objektivlinse erfolgt entweder über eine Anpassung aller Hexapolfeldstärken oder die Wahl der Zwischenvergrößerung zwischen Objektivlinse und Korrektiv.

Für die Möglichkeit der Korrektur ist es unerheblich, ob der Korrektor in Richtung des Strahlengangs und ggf. unter Zwischen schalten von Transferlinsen hinter der zu korrigierenden Linse angeordnet ist oder ob Korrektor und ggf. Transferlinsen vor der zur korrigierenden Linse angeordnet sind. Ziel ist immer durch Einstellung des Korrektors bzw. der Transferlinsen eine vollständige Elimination bestimmter Bildfehler des gesamten optischen Systems zu erreichen.

Weitere Einzelheiten, Merkmale und Vorteile der Erfindung lassen sich dem nachfolgenden Beschreibungsteil entnehmen, in dem anhand der Zeichnung Ausführungsbeispiele der Erfindung näher erläutert werden. Es zeigen:

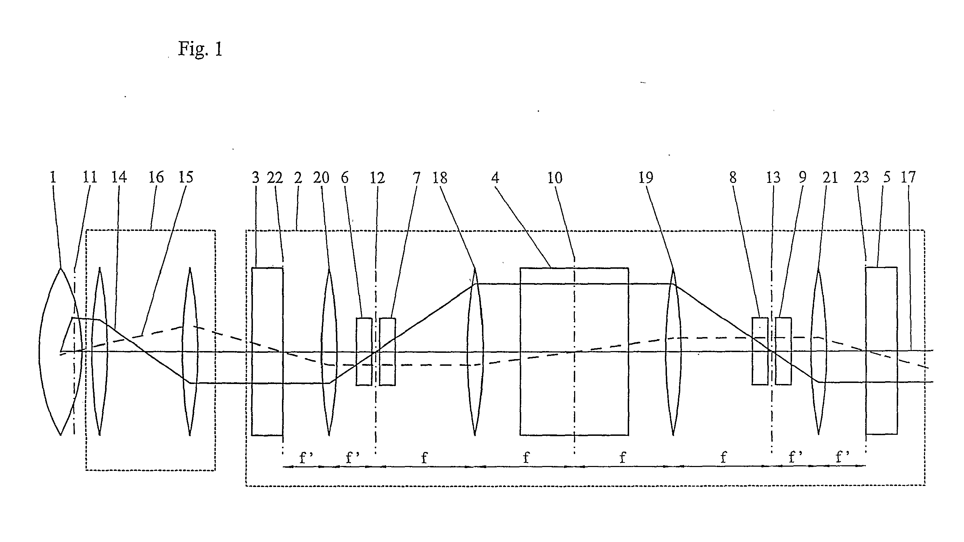

**Figur 1** Korrektor mit Hexapolfeldern und Verlauf der a. Fundamentalbahnen

**Figur 1** zeigt in prinzipienhaft gehaltener Seitenansicht den Aufbau einer elektronenoptischen Anordnung bestehend aus einer Objektivlinse 1, die in der Regel eine magnetische Rundlinse ist, einem Korrektor 2 und einem dazwischen angeordnetem Transferlinsensystem 16. Alle diese einzelnen Elemente haben die optische Achse 17 gemeinsam.
Der Korrektor 2 enthält 3 Hexapolfelder 3, 7, 8 und dazwischen geschaltete Rundlinsendupletts 18 - 21, die hintereinander angeordnet sind. Um die Ebenen 12,13 der Zwischenbilder (= Zwischenebenen) sind zwei Paare von Hexapolfelder 6 - 9 angeordnet. In Richtung des Strahlengangs steht ein erstes Hexapolfeld 3, dargestellt als Rechteck, eine erste Rundlinse 20 mit der Brennweite f'. Der Abstand zwischen Rundlinse 20 und Austrittsebene 22 des Hexapolfelds 3 entspricht der Brennweite f' der Rundlinse 20.

Hieran schließt sich ein Hexapolfeldpaar 6, 7 an. Die Zwischenebene 12 zwischen den Hexapolfelder 6, 7 befindet sich im Abstand f von der Rundlinse 20 und im Abstand f von der nachfolgenden Rundlinse 18 mit Brennweite f. Danach folgt ein weiteres Hexapolfeld 4, dessen Ausdehnung gemessen in z-Richtung länger ist als die Ausdehnung des ersten äußeren Hexapolfelds 3. Im Abstand f zur Rundlinse 18 befindet sich in der Mittelebene des Hexapolfelds 4 die Mittelebene 10 des Korrektivs. Vo hier ab setzt sich der Ausbau symmetrisch zur Mittelebene 10 fort. Die Hexapolfelder 3,10,5 sind symmetrisch zur Mittelebene 10 orientiert. Demgegenüber sind die schwachen Hexapolfeldpaare 6, 7,8, 9 antisymmetrisch zu den Ebenen 10, 12, 13 orientiert.

Zwischen der Objektivlinse 1 und dem Korrektor 2 ist ein aus zwei Rundlinsen bestehendes Transferlinsensystem 6 zwischengeschaltet. Dessen Einstellung erfolgt in der Weise, dass die komafreie Ebene 11 der Objektivlinse 1 in die komafreie Ebene 22 des Korrektors 2 abgebildet wird. Die axiale Fundamentalbahn 14 und die außeraxiale Fundamentalbahn 15 haben den in der Abbildung wiedergebenden Verlauf. Im Bereich des Korrektivs liegen Nullstellen der axialen Fundamentalbahn 14 in den Mittelebenen 12, 13 der Hexapolfeldpaare 6, 7 bzw. 8, 9 die der Korrektur der außeraxialen Koma dienen und Nullstellen der außeraxialen Fundamentalbahn 15 in der Austrittsebene 22 des ersten Hexapolfelds 3 und der Mittelebene 10 des Hexapolelements 4 sowie der Eintrittsebene 23 des Hexapolfelds 5. Durch entsprechende Einstellung des Transferlinsensystems 16 erhält man in der Gesamtheit mit Korrektor 2 ein Korrektursystem, das in der Lage ist, sowohl den Öffnungsfehler 3. Ordnung als auch die außeraxiale Koma, und zwar sowohl deren isotropen (radialen) als auch anisotropen (azimutalen) Anteil zu eliminieren.

**Patentansprüche**

1. Teilchenoptischer Korrektor zur Beseitigung sowohl des Öffnungsfehlers dritter Ordnung als auch der außeraxialen Koma dritter Ordnung unter Verwendung von Rundlinsen und Hexapolfeldern, **dadurch gekennzeichnet,**
   **dass** der Korrektor aus drei koaxial angeordnete Hexapolfelder (3 -5) besteht,
   und zwischen benachbarten Hexapolfeldern jeweils ein Rundlinsenduplett (18-21) angeordnet und derart eingestellt ist, dass die Ebene
   des mittleren Hexapolfelds (4) auf die benachbarten Hexapolfelder (3, 5) abgebildet wird, und hierbei zwischen den Hexapolfeldern (3,4,5) eine Zwischenebene (12, 13) zu liegen kommt und die Zwischenebenen (12, 13) zueinander konjugiert und die drei Hexapolfelder im Larmor-Bezugssystem gleich orientiert sind und die Stärken der drei Felder derart wählbar sind, dass der Bildfehlerkoeffizient des dreizähligen Astigmatismus zu 0 wird und der Korrektor zusätzlich zwei Hexapolfeldpaare (6 - 9) enthält, bei denen die Felder jeden Hexapoffeldpaares antisymmetrisch zueinander erregbar sind

und die Paare jeweils um die beiden Zwischenebenen (12,13) herum angeordnet sind,
und die Orientierung der Hexapolfeldpaare um einen solchen Winkel gegen die durch die Hexapolfelder (3 - 5) definierte Orientierung verdrehbar ist, dass die außeraxiale Koma 3. Ordnung korrigiert ist.

2. Korrektor nach Anspruch 1, **dadurch gekennzeichnet, dass** der Schwerpunkt des mittleren Hexapolfeldes (4) auf die diesem jeweils zugewandte Eintrittsebene (22, 23) der Hexapolfelder (3, 5) abgebildet wird.

3. Korrektor nach Anspruch 1 oder 2, **dadurch gekennzeichnet, dass** der Strahlengang zwischen dem ersten Hexapolfeld (3) und dem zweiten Hexapolfeld (4) und zwischen dem zweiten Hexapolfeld (4) und dem dritten Hexapolfeld (5) jeweils teleskopisch ist.

4. Korrektor nach einem der vorhergehenden Ansprüche , **dadurch gekennzeichnet, dass** die Stärke der Hexapolfeldpaare (6 - 9) max 1/10 der Stärke der Hexapolfelder (3 - 5) beträgt.

5. Korrektor nach einem der vorhergehenden Ansprüche, **dadurch gekennzeichnet,**
**dass** die Hexapolfeldpaare (6-9) im Larmor-Bezugssystem um einen Winkel von $\pm$ 30° gegen die Orientierung der Hexapolfelder (3-5) gedreht sind.

6. Korrektor nach einem der vorhergehenden Ansprüche, **dadurch gekennzeichnet,**
**dass** das Längenverhältnis der Hexapolfelder (3 - 5) so gewählt ist, dass der Bildfehlerkoeffizient der dreizähligen Verzeichnung 2. Ordnung zu 0 wird.

7. Korrektor nach einem der vorhergehenden Ansprüche, **dadurch gekennzeichnet,**
**dass** der Aufbau des Korrektors symmetrisch zur Mittelebene (10) ist,
und die Feldstärken derart gewählt sind, dass die axiale Fundamentalbahn (14) symmetrisch zur Mittelebene (10) des mittleren Hexapolfeldes (4) und die außeraxiale Fundamentalbahn (15) antisymmetrisch zu dieser Mittelebene (10) verläuft.

8. Korrektor nach einem der vorhergehenden Ansprüche, **dadurch gekennzeichnet,**
**dass** die Erregungen der Hexapolfelder (3 - 5) symmetrisch, und die der Hexapolfeldpaare (6 - 9) antisymmetrisch zur Mittelebene (10) gewählt sind.

9. Korrektor nach einem der vorhergehenden Ansprüche, **dadurch gekennzeichnet,**
**dass** die Brennweiten der Rundlinsen (18 - 21) zwischen den Hexapolfeldern (3 - 5) gleich gewählt sind, und **dass** die Fundamentalbahnen doppelsymmetrisch bezüglich der Mittelebene (10) des Korrektors und den Zwischenebenen (12,13) verlaufen.

10. Korrektor nach einem der vorhergehenden Ansprüche, **dadurch gekennzeichnet,**
**dass** die beiden dem mittleren Hexapolfeld (10) benachbarten Rundlinsen (18, 19) so modifiziert sind, dass sie bei gleicher Brennweite einen größeren Öffnungsfehlerkoeffizienten aufweisen als die anderen Rundlinsen (20, 21) des Korrektivs und durch geeignete Einstellung eine Elimination des Dreilappfehlers gestatten.

11. Korrektor nach einem der vorhergehenden Ansprüche, **dadurch gekennzeichnet,**
**dass** ein Hexapolfeld von einem Multipolelement mit 6-zähliger Drehsymmetrie erzeugt wird.

12. Korrektor nach einem der vorhergehenden Ansprüche, **dadurch gekennzeichnet,**
**dass** ein Hexapolfeld von einem Multipolelement mit 12-zähliger Drehsymmetrie erzeugt wird.

13. Korrektor nach einem der vorhergehenden Ansprüche, **dadurch gekennzeichnet,**
**dass** das mittlere Hexapolfeld (4) von einem Multipolelement mit mindestens 12-zähliger Drehsymmetrie erzeugt wird und auf dem gleichen Multipolelement ein Dodecapolfeld überlagert wird,
welches der Korrektur des sechszähligen Astigmatismus dient.

14. Korrektor nach einem der vorhergehenden Ansprüche, **dadurch gekennzeichnet,**
**dass** eine der Rundlinsen (18 - 21) aus mindestens zwei magnetischen Linsenfeldern zusammengesetzt ist,
die in ihrer jeweiligen Stärke individuell derart einstellbar sind, dass unter Beibehaltung der Brechkraft der Rundlinse deren Larmor-Drehung oder deren Öffnungsfehler einstellbar ist.

15. Korrektor nach einem der vorhergehenden Ansprüche, **dadurch gekennzeichnet,**
**dass** in Richtung auf die Objektivlinse (1) ein Transferlinsensystem (16) vorgeschaltet ist,
welches aus einer Rundlinse besteht und die derart eingestellt ist, dass sie die komafreie Ebene (11) der Objektivlinse (1) auf die komafreie Ebene (22) des Korrektors abbildet.

16. Korrektor nach einem der vorhergehenden Ansprüche, **dadurch gekennzeichnet,**
**dass** in Richtung auf die Objektivlinse (1) ein Transferlinsensystem (16) dem Korrektor (2) vorgeschaltet ist,
welches aus einem Rundlinsenduplett besteht, welches die komafreie Ebene (11) des Objektivs (1) auf die komafreie Ebene (22) des Korrektors abbildet.

17. Teilchenoptisches Abbildungssystem, **dadurch gekennzeichnet,**
    **dass** einem Korrektor nach einem der vorhergehenden Ansprüche eine Objektivlinse (1)
    und ein Transferlinsensystem (16) in Richtung des Strahlenganges vor- oder nachgeschaltet sind.

**Claims**

1. Particle-optical corrector for eliminating both the third-order aperture aberration and the third-order extra-axial coma using circular lenses and hexapole fields, **characterised in that**
   the corrector consists of three coaxially arranged hexapole fields (3-5),
   at least one circular lens doublet (18-21) being arranged between adjacent hexapole fields and adjusted such that the plane of centre hexapole field (4) is imaged on the hexapole fields (3,5), and thereby an intermediate plane (12, 13) comes to lie between the hexapole fields (3,4,5), and the intermediate planes (12, 13) are conjugated with one another, and the three hexapole fields are identically oriented in the Larmor reference system
   and the intensities of the hexapole fields are chosen such that the image aberration coefficient of the astigmatism with threefold symmetry becomes 0 and that the corrector additionally contains two hexapole field pairs (6-9), in which the fields of each hexapole field pair are excited antisymmetrically with respect to one another,
   and the pairs are arranged in each case around the two intermediate planes (12, 13),
   and the orientation of the hexapole field pairs is rotated with respect to the orientation defined by the hexapole fields (3-5) by an angle such that the extra-axial 3rd order coma is corrected.

2. Corrector according to claim 1, **characterised in that** the focal point of the centre hexapole field (4), is imaged on that entrance plane (22, 23) of the hexapole fields (3, 5) that is facing it.

3. Corrector according to claim 1 or 2, **characterised in that** the ray path is telescopic in each case between the first hexapole field (3) and the second hexapole field (4) and between the second hexapole field (4) and the third hexapole field (5).

4. Corrector according to one of the preceding claims, **characterised in that** the intensity of the hexapole field pairs (6 - 9) amounts to max. 1/10 of the intensity of the hexapole fields (3-5).

5. Corrector according to one of the preceding claims, **characterised in that** the hexapole field pairs (6-9) are rotated in the Larmor reference system about an angle of $\pm 30°$ with respect to the orientation of the hexapole fields (3-5)..

6. Corrector according to one of the preceding claims, **characterised in that** the length ratio of the hexapole fields (3 -5) is chosen such that the image aberration coefficient of the 2nd order distortion of threefold symmetry becomes 0.

7. Corrector according to one of the preceding claims, **characterised in that** the corrector is symmetrically constructed with respect to the centre plane (10) and **in that** the field intensities are chosen such that the axial fundamental path (14) is symmetrical to the centre plane (10) of the centre hexapole field (4) and the extra-axial fundamental path (15) is antisymmetrical with respect to this centre plane (10)

8. Corrector according to one of the preceding claims, **characterised in that** the excitations of the hexapole fields (3 - 5) are chosen so as to be symmetrical and **in that** the hexapole field pairs (6 - 9) are chosen so as to be antisymmetrical with respect to the centre plane (10).

9. Corrector according to one of the preceding claims, **characterised in that** the focal lengths of the circular lenses (18 - 21) between the hexapole fields (3 - 5) are chosen so as to be the same and **in that** the fundamental paths are doubly symmetrical with respect to the centre plane (10) of the corrector and the intermediate planes (12, 13).

10. Corrector according to one of the preceding claims, **characterised in that** the two circular lenses (18, 19), which are adjacent to the centre hexapole field (10), are modified such that, for the same focal length, they have a larger aperture aberration coefficient than the other circular lenses (20, 21) of the corrective, and by appropriate setting permit elimination of the three-leaf-clover aberration.

11. Corrector according to one of the preceding claims, **characterised in that** a hexapole field is generated by a multipole element with six-fold rotational symmetry.

12. Corrector according to one of the preceding claims, **characterised in that** a hexapole field is generated by a multipole element with twelve-fold rotational symmetry.

13. Corrector according to one of the preceding claims, **characterised in that** the centre hexapole field (4) is generated by a multipole element with at least twelve-fold rotational symmetry, and, on the same multipole element, a dodecapole field is superposed, which serves to correct the six-fold astigmatism.

14. Corrector according to one of the preceding claims, **characterised in that** one of the circular lenses (18 - 21) is composed of at least two magnetic lens fields, which are adjustable as regards their respective intensities such that their Larmor rotation or their aperture aberration is adjustable while maintaining the refractive power of the circular lens.

15. Corrector according to one of the preceding claims, **characterised in that**, in the direction of the objective lens (1), it is preceded by a transfer lens system (16), which consists of a circular lens and is adjusted such that it images the coma-free plane (11) of the objective lens (1) on the coma-free plane (22) of the corrector.

16. Corrector according to one of the preceding claims, **characterised in that**, in the direction of the objective lens (1), the corrector (2) is preceded by a transfer lens system (16), which consists of a circular-lens doublet, which images the coma-free plane (11) of the objective (1) in the coma-free plane (22) of the corrective.

17. Particle-optical imaging system **characterised in that** a corrector according to one of the preceding claims is, in the direction of the ray path, preceded by or succeeded by an objective lens (1) and a transfer lens system (16).

**Revendications**

1. Correcteur d'optique des particules, destiné à éliminer à la fois l'erreur d'ouverture de troisième ordre et la coma hors-axe de troisième ordre en utilisant des lentilles rondes et des champs d'hexapôles, **caractérisé par le fait**
que le correcteur consiste en trois champs d'hexapôles (3 - 5) disposés dans le sens coaxial, un doublet de lentilles rondes (18 - 21) étant disposé à chaque fois entre des champs voisins, et réglés de façon à ce que le niveau du champ d'hexapôle médian (4) soit représenté sur les champs d'hexapôles (3, 5) voisins, et à ce qu'à cette occasion un niveau intermédiaire (12, 13) viennent se constituer entre les champs d'hexapôles (3, 4, 5), les niveaux intermédiaires (12, 13) se conjuguant les uns avec les autres, les trois champs d'hexapôles étant orientés de la même manière dans le système de référence de Larmor, les puissances des trois champs pouvant être choisies de façon à ce que le coefficient d'erreur d'image de l'astigmatisme à trois chiffres soit 0 et à ce que le correcteur contienne en outre deux paires d'hexapôles (6 - 9), dans lesquels les champs de chaque paire d'hexapôles peuvent être excités de façon asymétrique les uns par rapport aux autres, chaque paire étant disposée autour des deux niveaux intermédiaires (12, 13, l'orientation définie par les paires d'hexapôles (3 - 5) pouvant effectuer une rotation de façon à ce que la coma hors-axe de 3ème ordre soit corrigée

2. Correcteur selon la revendication 1, **caractérisé par le fait que** le centre de gravité du champ d'hexapôle médian (4) est représenté sur chaque niveau d'entrée (22, 23) des champs d'hexapôles (3, 5) orientée à chaque fois vers lui.

3. Correcteur selon la revendication 1 ou 2, **caractérisé par le fait que** la course du rayon entre le premier champ d'hexapôle (3) et le second champ d'hexapôle (4), et entre le second champ d'hexapôle (4) et le troisième champ d'hexapôle (5) est à chaque fois télescopique.

4. Correcteur selon une des revendications précédentes, **caractérisé par le fait que** la puissance des paires de champs d'hexapôles (6 - 9) représente au maximum 1/10 de la puissance des champs d'hexapôles (3 - 5).

5. Correcteur selon une des revendications précédentes, **caractérisé par le fait que** les paires de champs d'hexapôles (6 - 9) dans le système de référence de Larmor sont tournées d'un angle de $\pm$ 30° contre l'orientation des champs d'hexapôles (3 - 5).

6. Correcteur selon une des revendications précédentes, **caractérisé par le fait que** le rapport de longueur des champs d'hexapôles (3 - 5) est choisi de façon à ce que le coefficient d'erreur d'image de la distorsion à trois chiffres de 2ème ordre soit de 0.

7. Correcteur selon une des revendications précédentes, **caractérisé par le fait que** la structure du correcteur est asymétrique par rapport au niveau médian devient 0, et que les puissances des champs soit choisies de façon à ce que la voie axiale fondamentale (14) suive un tracé symétrique par rapport au niveau médian (10) du champ d'hexapôle médian (4) et à ce que la voie hors-axial fondamentale (15) suive un tracé antisymétrique par rapport à ce niveau médian (10).

8. Correcteur selon une des revendications précédentes, **caractérisé par le fait que** les excitations des champs d'hexapôles (3 - 5) sont choisies de façon symétrique, et les paires de champs d'hexapôles (6 - 9) sont choisies de façon asymétrique par rapport au niveau médian (10).

9. Correcteur selon une des revendications précédentes, **caractérisé par le fait que** les focales choisies pour les lentilles rondes (18 - 21) sont les mêmes, et que les voies fondamentales suivent un tracé doublement symétrique par rapport au niveau médian (10) du correcteur et aux niveaux intermédiaires (12, 13).

10. Correcteur selon une des revendications précédentes, **caractérisé par le fait que** les deux lentilles rondes (18 -19) voisines du champ d'hexapôle médian (10) sont modifiées de façon à présenter, lorsqu'elles ont les mêmes focales, un coefficient d'erreur d'ouverture supérieur aux autres lentilles rondes (20, 21) du correctif en permettant, grâce à un réglage adapté, une élimination de l'erreur trilobée.

11. Correcteur selon une des revendications précédentes, **caractérisé par le fait qu'**un champ d'hexapôle est généré par un élément multipôle présentant une symétrie rotative à 6 chiffres.

12. Correcteur selon une des revendications précédentes, **caractérisé par le fait qu'**un champ d'hexapôle est généré par un élément multipôle présentant une symétrie rotative à 12 chiffres.

13. Correcteur selon une des revendications précédentes, **caractérisé par le fait que** le champ d'hexapôle médian (4) est généré par un élément multipôle présentant une symétrie rotative d'au moins 12 chiffres, un champ dodécapôle servant à la correction de l'astigmatisme à six chiffres étant superposé sur le même élément dodécapôle.

14. Correcteur selon une des revendications précédentes, **caractérisé par le fait qu'**une des lentilles rondes (18 - 21) est composée d'au moins deux champs magnétiques de lentilles pouvant être réglés individuellement dans leur puissance respective de façon à ce que leur rotation de Larmor ou leur erreur d'ouverture puisse être réglée en conservant la vergence de la lentille ronde.

15. Correcteur selon une des revendications précédentes, **caractérisé par le fait qu'**un système de lentilles de transfert (16) est branché en amont en direction de la lentille de l'objectif (1), qui consiste en une lentille ronde, en étant réglé de façon à représenter le niveau sans coma (11) de la lentille de l'objectif (1) sur le niveau sans coma (22) du correcteur.

16. Correcteur selon une des revendications précédentes, **caractérisé par le fait qu'**un système de lentilles de transfert (16) est branché en amont en direction de la lentille de l'objectif (1), qui consiste en un doublet de lentilles rondes, en étant réglé de façon à représenter le niveau sans coma (11) de la lentille de l'objectif (1) sur le niveau sans coma (22) du correcteur.

17. Système de représentation d'optique des particules, **caractérisé par le fait qu'**une lentille d'objectif (1) et un système de lentille de transfert (16) est branché en amont ou en aval dans le sens de la course du rayon dans le cas d'un correcteur selon une des revendications précédentes.

Fig. 1

**IN DER BESCHREIBUNG AUFGEFÜHRTE DOKUMENTE**

**In der Beschreibung aufgeführte Patentdokumente**

- DE 19802409
- WO 102005050810 A